(19) Europäisches Patentamt
European Patent Office
Office européen des brevets

(11) Veröffentlichungsnummer: **0 363 505**
**A1**

(12) **EUROPÄISCHE PATENTANMELDUNG**

(21) Anmeldenummer: 88116818.1

(51) Int. Cl.5: **H03K 19/003** , **H03K 17/16**

(22) Anmeldetag: 11.10.88

(43) Veröffentlichungstag der Anmeldung:
18.04.90 Patentblatt 90/16

(84) Benannte Vertragsstaaten:
DE FR GB

(71) Anmelder: International Business Machines
Corporation
Old Orchard Road
Armonk, N.Y. 10504(US)

(72) Erfinder: Wagner, Otto Martin, Dipl.-Ing.
Buchenweg 36/1
D-7031 Altdorf(DE)
Erfinder: Zühlke, Rainer, Dipl.-Ing.
Rainstrasse 3
D-7250 Leonberg 7(DE)
Erfinder: Ludwig, Thomas, Dipl.-Ing.
Rösslesmühlestrasse 8
D-7032 Sindelfingen(DE)
Erfinder: Schettler, Helmut, Dipl.-Ing.
Jägerstrasse 23
D-7405 Dettenhausen(DE)

(74) Vertreter: Neuland, Johannes, Dipl.-Ing.
IBM Deutschland GmbH Schönaicher
Strasse 220
D-7030 Böblingen(DE)

(54) Verfahren und Schaltungsanordnung zum Erhöhen der Ausgangsimpedanz auf einen Vorgegebenen Wert beim Schalten eines in CMOS-Technologie aufgeführten integrierten Leistungsverstärkers.

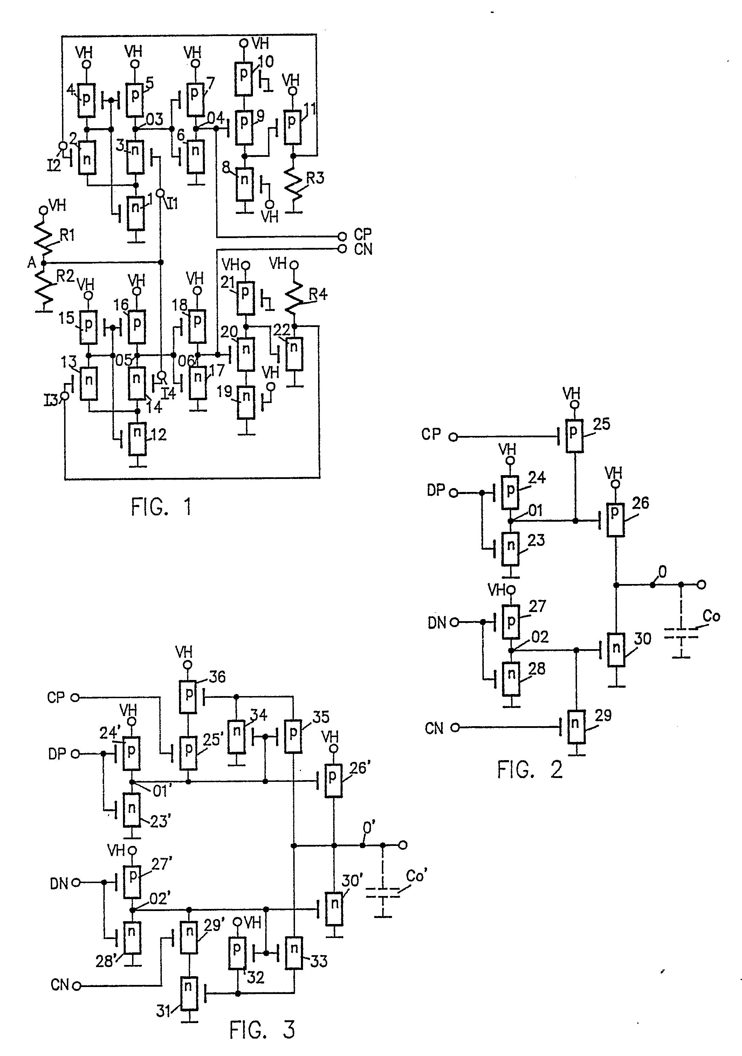

(57) Zur Verringerung der beim gleichzeitigen Schalten mehrerer Leistungsverstärker aufgrund des Induktionsgesetzes entstehenden Störspannung $u_L = -Ldi/dt$ wird die Ausgangsimpedanz der Leistungsverstärker beim Schalten zwischen zwei Spannungspegeln auf einen vorgegebenen Wert erhöht. Dazu wird die Steuerspannung des jeweils schaltenden Endstufentransistors (26, 30) mit Hilfe des Stromes eines Zusatz-Feldeffekttransistors (25, 29) verringert, dessen Drain mit dem Ausgang (O1, O2) der Vorstufe und dem Gate des Endstufen-Feldeffekttransistors verbunden ist. Dem Gate des Zusatz-Feldeffekttransistors wird eine Spannung zugeführt, die in einer Regelschaltung (Fig. 1) gewonnen wird. Diese enthält je einen Differenzverstärkers (1-5; 12-16) für jeden Endstufen-Feldeffekttransistor des Leistungsverstärkers. Seinem ersten Eingang (I1, I4) wird die durch einen Spannungsteiler (R1, R2) halbierte Betriebsspannung VH/2 zugeführt. Der zweite Eingang (I2, I3) ist an den Verbindungspunkt eines Widerstandes (R3, R4), der die gewünschte erhöhte Ausgangsimpedanz des Endstufen-Feldeffekttransistors vorgibt, mit der Drain eines ihn nachbildenden Feldeffekttransistors (11, 12) verbunden. An dessen Gate sind auch die Drain-Elektroden zweier Feldeffekttransistoren (8, 9; 20, 21) angeschlossen, die den Zusatz-Feldeffekttransistor und den den Endstufen-Feldeffekttransistor steuernden Vorstufen-Feldeffekttransistor nachbilden. An den Ausgang des Differenzverstärkers ist ein Inverter (6, 7; 17, 18) angeschlossen. Mit seinem Ausgang (O4, O6) ist das Gate des den Zusatz-Feldeffekttransistor nachbildenden Feldeffekttransistors (9, 20) verbunden und die Gate-Elektroden der entsprechenden Zusatz-Feldeffekttransistoren aller Leistungsverstärker, deren Ausgangsimpedanz beim Schalten auf einen vorgegebenen Wert erhöht werden soll.

FIG. 2

FIG. 1

## Verfahren und Schaltungsanordnung zum Erhöhen der Ausgangsimpedanz auf einen vorgegebenen Wert beim Schalten eines in CMOS-Technologie ausgeführten integrierten Leistungsverstärkers

Die Erfindung betrifft ein Verfahren und eine Schaltungsanordnung zum Erhöhen der Ausgangsimpedanz auf einen vorgegebenen Wert beim Schalten eines in CMOS-Technologie ausgeführten integrierten Leistungsverstärkers zwischen zwei Spannungspegeln.

Bei der parallelen Datenübertragung in Computern müssen mehrere Leistungsverstärker gleichzeitig ein- oder ausgeschaltet werden. Die beim Schaltvorgang in den Versorgungsleitungen auftretende Stromänderung ruft aufgrund der Induktivität $L$ dieser Leitungen eine Störspannung $u_L$ hervor, deren Größe sich nach dem Induktionsgesetz zu $u_L = -L(di/dt)$ bestimmt. Je mehr Leistungsverstärker gleichzeitig schalten und je schneller sie dies tun, d.h. je geringer ihre Ausgangsimpedanz ist, um so größer ist die unerwünschte Störspannung auf den Versorgungsleitungen. Dadurch können Schaltkreise auf demselben Halbleiterchip in ihrer richtigen Funktionsweise gestört werden. Leistungsverstärker, die in einem Schaltzustand verharren, und deren Ausgangsleitungen mit anderen Halbleiterchips verbunden sind, übertragen die induzierte Störspannung dahin, die dort als Datenänderung von den Empfängerschaltkreisen interpretiert werden können und dann zu Fehlfunktionen führen.

Um einen fehlerfreien Betrieb eines Computers zu gewährleisten, muss daher dafür gesorgt werden, daß die genannte Störspannung unterhalb der Schaltschwelle der Speicherglieder bleibt. Man hat sich deshalb in der Vergangenheit damit beholfen, die Leistungsverstärker, deren gleichzeitiges Schalten zwar erwünscht, aber aus Gründen der Störspannungserzeugung nicht durchführbar war, gruppenweise zusammenzufassen und die Gruppen zeitlich gestaffelt zu schalten. Dadurch wird jedoch die Geschwindigkeit der Datenübertragung vermindert.

Aus der europäischen Patentanmeldung 86 114 573 (Veröffentlichungsnummer 264 470) sind bereits ein Verfahren und eine Schaltungsanordnung zur Verringerung der erwähnten, beim gleichzeitigen Schalten mehrerer Leistungsverstärker entstehenden Störspannung bekannt. Nach der Lehre dieser Patentanmeldung wird die Störspannung dadurch vermindert, daß die Flankensteilheit der Ausgangssignale der Leistungsverstärker über eine digitale Regelschaltung beeinflußt wird. Dabei wird der Istwert der Flankensteilheit über die Anzahl von Taktimpulsen erfaßt, die einem Zähler während eines Messintervalls zugeführt werden, dessen Dauer von der Flankensteilheit abhängig ist. Ein solches Messintervall wird erzeugt durch Zuführen der Impulse eines Ringoszillators, der einen der Leistungsverstärker enthält, zu einem weiteren Zähler bis zu dessen Überlauf. Ist- und Sollwert der Flankensteilheit werden verglichen. Das Vergleichsergebnis ändert den Inhalt eines Links/Rechts-Schieberegisters. Seine Parallelausgänge beeinflussen über Steuerleitungen Steuereingänge der Leistungsverstärker, um deren Flankensteilheit durch Zu-oder Abschalten von hinsichtlich ihrer Schaltstrecken parallel geschalteten Ausgangstransistoren zu ändern.

Die bekannte Lösung zur digitalen Regelung der Flankensteilheit der Ausgangssignale von Leistungsverstärkern erfordert einen beträchtlichen zusätzlichen Schaltungsaufwand für den Ringoszillator, die Zähler, die Vergleichsschaltung und das Schieberegister und ist darüber hinaus nicht in asynchron arbeitenden Datenverarbeitungsanlagen oder innerhalb von asynchron betriebenen Teilen einer Anlage, die als ganzes synchron arbeitet, einsetzbar. Hier will die Erfindung Abhilfe schaffen. Die Erfindung, wie sie in den Ansprüchen gekennzeichnet ist, löst die Aufgabe, ein Verfahren und eine Schaltungsanordnung anzugeben zum Erhöhen der Ausgangsimpedanz auf einen vorgegebenen Wert beim Schalten eines Leistungsverstärkers zwischen zwei Spannungspegeln, da die zeitliche Änderung des Stromes und damit die beim Schalten entstehende unerwünschte Störspannung um so geringer ist, je höher die Ausgangsimpedanz des Leistungsverstärkers ist.

Die durch die Erfindung erreichten Vorteile sind im wesentlichen darin zu sehen, daß einmal der zur Durchführung des Verfahrens gemäß der Erfindung erforderliche Schaltungsaufwand gegenüber dem für die Lösung nach der europäischen Patentanmeldung 86 114 573 wesentlich geringer ist und zum anderen die Erfindung auch in einer asynchron arbeitenden Datenverarbeitungsanlage bzw. in asynchron arbeitenden Teilen einer Anlage, die als Ganzes synchron arbeitet, eingesetzt werden kann.

Im folgenden wird die Erfindung in Verbindung mit den Zeichnungen näher erläutert, von denen zeigen:

Fig.1 das Schaltbild einer für die Durchführung des erfindungsgemäßen Verfahren benötigten Regelschaltung;

Fig.2 das Schaltbild eines ersten Leistungsverstärkers zur Durchführung des erfindungsgemäßen Verfahrens; und

Fig.3 das Schaltbild einer verbesserten Ausführungsform eines Leistungsverstärkers zur Durchführung des erfindungsgemäßen Verfahrens;

In Fig.1 ist das Schaltbild einer zur Durchführung des erfindungsgemäßen Verfahrens verwendeten Regelschaltung wiedergegeben, mittels derer die Ausgangsimpedanz eines integrierten und in CMOS-Technologie ausgeführten Leistungsverstärkers nach Fig.2 oder Fig.3 beim Schalten von einem ersten in einen zweiten Spannungspegel und umgekehrt auf einen vorgegebenen Wert gebracht wird. Die Regelschaltung besteht aus zwei Teilen, die bis auf den Leitungstyp der Feldeffekttransistoren 9 und 20, sowie 11 und 22 und die Anordnung der Widerstände R3 und R4 gleichartig aufgebaut sind. Im folgenden wird für den Begriff Feldeffekttransistor die Abkürzung FET benutzt. Die Regelschaltung besitzt zwei Ausgänge CP und CN. Am Ausgang CP liegt eine Regelspannung vor, über die die Ausgangsimpedanz des p-leitenden Endstufen-FET 26 bzw. 26′ des weiter unten beschriebenen Leistungsverstärkers nach Fig.2 bzw. Fig.3 mit Hilfe eines die Gatespannung des FET 26 bzw. 26′ beeinflußenden Zusatz-FETs 25 bzw. 25′ erhöht wird. Die am Ausgang CN der Regelschaltung erscheinende Regelspannung dient der Erhöhung der Ausgangsimpedanz des n- leitenden Endstufen-FETs 30 bzw. 30′. Jede der beiden Teile der Regelschaltung weist einen aus den n-leitenden FETs 1, 2 und 3 bzw. 12, 13 und 14 und den als Last-FETs dienenden p- leitenden FETs 4 und 5 bzw. 15 und 16 bestehenden üblichen Differenzverstärker in CMOS-Technologie auf. Die Gate-Elektroden der p-leitenden FET 4 und 5 bzw. 15 und 16 sind miteinander und mit dem Gate des eine Konstantstromquelle bildenden, n-leitenden FET 1 bzw. 12 verbunden. Außerdem sind die genannten Gate-Elektroden an den Verbindungspunkt der FET 2 und 4 bzw. 13 und 15 angeschlossen. Der Verbindungspunkt der beiden FET 3 und 5 bzw. 14 und 16 bildet den Ausgang O3 bzw. O5 des Differenzverstärkers. Die Source des n-leitenden FET 1 bzw. 12 ist an das Bezugspotential und die Source-Elektroden der FET 4 und 5 bzw. 15 und 16 sind an den positiven Pol VH der Betriebsspannungsquelle angeschlossen. Das den einen Eingang I1 bzw. I4 des Differenzverstärkers bildende Gate des n-leitenden FET 3 bzw. 14 ist an den Abgriff A eines aus den beiden gleichen Widerständen R1 und R2 gebildeten Spannungsteilers angeschlossen, der parallel zur Betriebsspannungsquelle geschaltet ist und an dessen Abgriff A daher eine Spannung von der halben Größe der Betriebsspannung vorliegt. Die beiden Zweige des Differenzverstärkers, die aus den FET 2 und 4 bzw. 13 und 15, sowie 3 und 5 bzw. 14 und 16 bestehen, sind gleich dimensioniert, so daß im Ruhezustand des Differenzverstärkers in beiden Zweigen die Hälfte des von der Konstantstromquelle 1 bzw. 12 gelieferten Stromes fließt. Der Ausgang O3 bzw. O5 des Differenzverstärkers ist mit dem Eingang eines aus den komplementären FETs 6 und 7 bzw.

17 und 18 gebildeten Inverters verbunden, dessen Ausgang O4 bzw. O6 an das Gate des p-leitenden FET 9 bzw. des n-leitenden FET 20 angeschlossen ist, der der mittlere FET einer Reihenschaltung aus den FET 8, 9 und 10 bzw. 19, 20 und 21 ist. Der Verbindungspunkt der FET 8 und 9 bzw. 20 und 21 ist an das Gate eines den Endstufen-FET 26 oder 26′ bzw. 30 oder 30′ des Leistungsverstärkers nachbildenden FET 11 bzw. 22 angeschlossen. Mit der Drain des FET 11 bzw. 22 ist das eine Ende eines Widerstandes R3 bzw. R4 verbunden, dessen Wert den gewünschten erhöhten Wert der Ausgangsimpedanz des Leistungsverstärkers bzw. ein ganzzahliges Vielfaches davon angibt. Das andere Ende des Widerstandes R3 bzw. R4 ist an das Bezugspotential bzw. an den positiven Pol VH der Betriebsspannungsquelle angeschlossen. Der Verbindungspunkt des FET 11 bzw. 22 mit dem Widerstand R3 bzw. R4 ist mit dem anderen Eingang I2 bzw. I3 des Differenzverstärkers verbunden, der durch das Gate des n- leitenden FET 2 bzw. 13 gebildet wird. Die für die Regelschaltung nach Fig.1 erforderliche Nachbildung der wesentlichen Teile des Lei stungsverstärkers nach Fig.3 enthält den den Endstufen-FET 26′ bzw. 30′ nachbildenden FET 11 bzw. 22, den n-leitenden FET 8 bzw. den p-leitenden FET 21 als Nachbildung des FET 23′ bzw. 27′ der Vorstufe und einen Zusatz-FET 9 bzw. 20 als Nachbildung des Zusatz FET 25′ bzw. 29′, der mit seiner Drain an das Gate des FET 11 bzw. 22 angeschlossen ist. Die in Fig.1 noch dargestellten ständig leitenden FET 10 bzw. 19 sind für das Erhöhen der Ausgangsimpedanz eines Leistungsverstärkers nach Fig.2 nicht erforderlich. Sie werden für die Nachbildung der wesentlichen Teile des verbesserten Leistungsverstärkers nach Fig.3 benötigt. Ihre Bedeutung wird bei der Beschreibung dieses Verstärkers dargelegt.

Die Wirkungsweise der Regelschaltung nach Fig.1 ist folgende:

Nach dem Anlegen der Betriebsspannung wird dem als Referenzeingang (I1 bzw. I4) des Differenzverstärkers dienenden Gate des FET 3 bzw. 14 vom Abgriff A des aus den gleichgroßen Widerständen R1 und R2 gebildeten Spannungsteilers eine Spannung von der halben Größe von der Betriebsspannung zugeführt. Aufgrund der gleichen Dimensionierung des linken und des rechten Zweiges des Differenzverstärkers verteilt sich der von dem als Konstantstromquelle arbeitenden n-leitenden FET 1 bzw. 12 gelieferte Strom zu gleichen Teilen auf die beiden Zweige 2, 4 und 3, 5 bzw. 13, 15 und 14, 16 des Differenzverstärkers. Das bedeutet aber, daß das Gatepotential des FET 2 bzw. 13 ebenso groß ist wie das des FET 3 bzw. 14, nämlich VH/2. Aufgrund der Verbindung des Gate von FET 2 bzw. 13 mit dem Verbindungspunkt des FET 11 mit dem Widerstand R3 bzw. des FET 22 mit dem Widerstand R4 beträgt das Potential an diesem Verbindungspunkt ebenfalls VH/2. Dies heißt aber, daß die Impedanz des FET 11 bzw. 22 gleich ist dem Wert des Widerstandes R3 bzw. R4.

Die am Ausgang O4 bzw. O6 des aus den FETs 6 und 7 bzw. 17 und 18 bestehenden Inverters vorliegende verstärkte Ausgangsspannung des Differenzverstärkers 1 - 5 bzw. 12 - 16 wird als Regelspannung außer der Nachbildung der für die Regelung wesentlichen Teile des Leistungsverstärkers auch dem Gate von dessen in Fig.2 dargestellten Zusatz- FET 25 bzw. 29 zugeführt. Dadurch wird die durch die Widerstände R3 und R4 der Regelschaltung vorgegebene erhöhte Ausgangsimpedanz des Endstufen-FET 26 bzw. 30 erzielt. Die Regelschaltung nach Fig.1 sorgt dabei dafür, daß der durch den Widerstand R3 bzw. R4 vorgegebene Wert für die Ausgangsimpedanz eingehalten wird. Würde nämlich im rechten Zweig 3, 5 des Differenzverstärkers 1 - 5 mehr Strom als im linken fließen, würde das Potential am Ausgang O3 absinken und am Ausgang O4 des Inverters 6, 7 ansteigen. Dadurch wird der FET 9 hochohmiger und das Potential am Verbindungspunkt der FET 8 und 9 und damit das Gatepotential des FET 11 absinken. Der FET 11 wird dadurch stärker leitend, wodurch das Potential am Verbindungspunkt des FET 11 mit dem Widerstand R3 ansteigt. Durch dieses ansteigende Potential wird der FET 2 im linken Zweig 2, 4 des Differenzverstärkers niederohmiger, bis in seinen beiden Zweigen 2,4 und 3,5 wieder ein gleichgroßer Strom fließt.

Steigt das Potential am Ausgang O3 des Differenzverstärkers 1 - 5 an, sinkt es am Ausgang O4 des Inverters 6, 7 ab. Dadurch wird der FET 9 stärker leitend, was einen Potentialanstieg am Verbindungspunkt der FET 8 und 9 und damit am Gate des FET 11 zur Folge hat. Dieser wird schwächer leitend, was eine Potentialabsenkung am Verbindungspunkt des FET 11 mit dem Widerstand R3 zur Folge hat. Diese Potentialabsenkung wird zum Gate des FET 2 übertragen, bis in beiden Zweigen 2,4 und 3,5 des Differenzverstärkers 1 - 5 wieder der gleiche Strom fließt.

Fließt im rechten Zweig 14, 16 des Differenzverstärkers 12-16 mehr Strom als in seinem linken Zweig 13, 15, sinkt das Potential am Ausgang O5 ab und steigt am Ausgang O6 des Inverters 17, 18 und damit am Gate des n-leitenden FET 20 an. Dieser FET wird niederohmiger. Dadurch sinkt das Potential am Verbindungspunkt des FET 20 mit dem p-leitenden FET 21 und damit am Gate des n-leitenden FET 22. Dieser wird hochohmiger. Dadurch steigt das Potential am Verbindungspunkt des FET 22 mit dem Widerstand R4. Der Potentialanstieg wird an das Gate des FET 13 übertragen, der dadurch stärker leitend wird, bis in beiden Zweigen 13, 15 und 14, 16 des Differenzverstärkers 12 - 16 wieder der gleiche Strom fließt.

Fließt im linken Zweig 13, 15 des Differenzverstärkers 12-16 mehr Strom als in seinem rechten Zweig 14, 16, so steigt das Potential am Ausgang O5 an und sinkt am Ausgang O6 des Inverters 17, 18 und damit am Gate des n-leitenden FET 20. Dieser wird hochohmiger. Dadurch steigt das Potential am Verbindungspunkt der FET 20 und 21 und damit am Gate des n-leitenden FET 22 an. Dieser wird niederohmiger. Das hat eine Potentialabsenkung am Verbindungspunkt von FET 22 mit dem Widerstand R4 zur Folge. Die Potentialabsenkung wird an das Gate des FET 13 übertragen, der dadurch weniger stark leitend wird, bis in beiden Zweigen 13, 15 und 14, 16 des Differenzverstärkers 12-16 wieder der gleiche Strom fließt.

Da die am Ausgang O4 bzw. O6 des Inverters 6, 7 bzw. 17, 18 vorliegende Regelspannung über den Ausgang CP bzw. CN der Regelschaltung auch dem Endstufen-FET 26 bzw. 30 zugeführt wird, weist auch dieser die vorgegebene Impedanz auf.

In Fig.2 ist das Schaltbild eines ersten Leistungsverstärkers zur Durchführung des erfindungsgemäßen Verfahrens wiedergegeben. Es unterscheidet sich von einem üblichen, die Vorstufen-FET 23 und 24 sowie 27 und 28 und die Endstufen-FET 26 und 30 enthaltenden durch die beiden Zusatz-FET 25 und 29, die vom gleichen Leitfähigkeitstyp sind wie der zugehörige Endstufen-FET. Jeder Zusatz-FET ist mit seiner Drain mit dem Ausgang O1 bzw. O2 der Vorstufe verbunden und mit seiner Source an den positiven Pol VH der Betriebsspannungsquelle bzw. an den negativen, mit dem Bezugspotential verbundenen Pol angeschlossen. Dem Gate des dem p-leitenden Endstufen-FET 26 zugeordneten Zusatz-FET 25 wird die am Ausgang CP der Regelschaltung vorliegende Regelspannung zugeführt und dem Gate des dem n-leitenden Endstufen-FET 30 zugeordneten Zusatz-FET 29 die am Ausgang CN der Regelschaltung vorliegende Regelspannung. Die beiden Zusatz-FET sind daher ständig leitend.

Zur Erklärung der Wirkungsweise des Leistungsverstärkers wird angenommen, daß an seinem Ausgang ein niedriges Potential vorliegt und der Leistungsverstärker in den Zustand hohen Ausgangspotentials schalten soll. Dazu wird seinem Dateneingang DP der hohe Signalpegel zugeführt, wodurch der n-leitenden Vorstufen-FET 23 leitend wird und dem Gate des p-leitenden Endstufen-FET 26 ein negatives Potential zugeführt wird. Dadurch wird der Endstufen-FET 26 rasch leitend und lädt die an seinem Ausgang wirksame, gestrichelt gezeichnete Kapazität $C_O$ rasch auf den Wert der Betriebsspannung VH auf.

Um die beim Schalten des Endstufen-FET 26 auftretende zeitliche Stromänderung und damit auch die entstehende Störspannung $u_L = -Ldi/dt$ zu verringern, wird die Ausgangsimpedanz des Endstufen-FET 26 mit Hilfe des Zusatz-FET 25 auf den vorgegebenen Wert erhöht. Das geschieht in der Weise, daß der den p-leitenden Zusatz-FET 25 durchfließende Strom, dessen Größe von der seinem Gate zugeführten Regelspannung abhängt, den n-leitenden FET 23 der Vorstufe durchfließt und dadurch deren Ausgangspotential anhebt. Dadurch wird das Gatepotential des p-leitenden Endstufen-FET 26 so weit verringert, daß dieser die gewünschte erhöhte Ausgangsimpedanz aufweist.

Soll sich das Ausgangspotential des Leistungsverstärkers von seinem hohen auf den niedrigen Wert ändern, wird über seinem Dateneingang DN dem Gate des p-leitenden Vorstufen-FET 27 ein negatives Potential zugeführt. Dadurch wird der p-leitende FET 27 leitend und führt dem Gate des n-leitenden Endstufen-FET 30 positives Potential zu. Dieser wird leitend und entlädt die Ausgangskapazität $C_O$. Um die zeitliche Änderung des Entladestroms zu begrenzen, erhält das Gate des n-leitenden Zusatz-FET 29 positives Potential, wodurch dieser FET leitend wird und einen Teil der positiven Ladung des Gates des n-leitenden Endstufen-FET 30 abfließen läßt. Dadurch, daß dem Gate des Zusatz-FET 29 die Regelspannung vom Ausgang CN der Regelschaltung zugeführt wird, wird erreicht, daß für den Schaltvorgang des n-leitenden Endstufen-FET 30 die gewünschte erhöhte Ausgangsimpedanz maßgebend ist.

In Fig.3 ist das Schaltbild eines Leistungsverstärkers wiedergegeben, der eine verbesserte Ausführungsform gegenüber dem nach Fig.2 darstellt. FET, die denen nach Fig.2 entsprechen, sind mit den gleichen, jedoch mit einem hochgestellten Strich versehenen Bezugszahlen bezeichnet. Die Ausführungsform nach Fig.3 hat gegenüber der nach Fig.2 den Vorteil, daß nach dem Erreichen des gewünschten Pegels am Ausgang O′ des Leistungsverstärkers der Stromfluß durch den Zusatz-FET 25′ bzw. 29′ und den beiden leitenden Vorstufen-FET 23′ bzw. 28′ unterbrochen wird und damit keine Gleichstromverlustleistung erzeugt wird. Bei dem Leistungsverstärker nach Fig.2 wird eine solche Gleichstromverlustleistung erzeugt, da der Zusatz-FET aufgrund der seinem Gate zugeführten Regelspannung ständig leitend ist und der Vorstufen-FET 23 bzw. 28 ebenfalls, solange der Pegel am Ausgang O des Leistungsverstärkers sich nicht ändert.

Die Schaltung nach Fig.3 ist um einen mit dem jeweiligen Zusatz-FET 25′ bzw. 29′ in Reihe geschalteten weiteren FET 36 bzw. 31, der den gleichen Leitungstyp wie der zugehörige Zusatz-FET aufweist, sowie um je zwei komplementäre FET 34 und 35 bzw. 32 und 33 erweitert. Die Gates dieser beiden komplementären FET sind miteinander und dem Gate des zugehörigen Endstufen-FET 26′ bzw. 30′ verbunden. Die Source des FET 34 ist an das Bezugspotential, seine Drain an das Gate des FET 36 und die Drain des p-leitenden FET 35 angeschlossen. Dessen Source ist mit dem Ausgang O′ des Leistungsverstärkers verbunden. Die Source des p-leitenden FET 32 ist an den positiven Pol VH der Betriebsspannungsquelle angeschlossen, seine Drain an das Gate des mit dem Zusatz-FET 29′ in Reihe liegenden FET 31 und die Source des n-leitenden FET 33 ist ebenfalls mit dem Gate des FET 31 verbunden. Seine Drain ist an den Ausgang O′ des Leistungsverstärkers angeschlossen.

Die Wirkungsweise dieser Schaltung wird anhand des Schaltvorganges beschrieben, durch den das Ausgangspotential des Leistungsverstärkers von seinem niedrigen auf den hohen Pegel gebracht wird. Dazu wird dem Eingang DP des Leistungsverstärkers positives Potential zugeführt, wodurch der n-leitende Vorstufen-FET 23′ leitend wird und dem Gate des p-leitenden Endstufen-FET 26′ negatives Potential zuführt. Dadurch wird dieser FET leitend und beginnt die Ausgangskapazität $C_O$ aufzuladen. Dem Gate des p-leitenden FET 35 wird ebenfalls das Potential, das am Ausgang O1′ der Vorstufe vorhanden ist, zugeführt. Daher ist dieser Transistor leitend und schaltet das ansteigende Potential am Ausgang O′ des Leistungsverstärkers zum Gate des p-leitenden FET 36 durch. Dadurch ist der FET 36 zunächst leitend. Damit sind der FET 36, der Zusatz-FET 25′ und der n-leitende Vorstufen-FET 23′ leitend. Der am Ausgang O1′ der Vorstufe durch den Strom des Zusatztransistors 25′ beim Durchfließen des n-leitenden Vorstufen-FET 23′ hervorgerufene Potentialanstieg sorgt für die beim Schaltvorgang erwünschte erhöhte Ausgangsimpedanz des Leistungsverstärkers.

Sobald das Ausgangspotential O′ den hohen Wert erreicht hat, wird es über den FET 35 auch dem Gate des p-leitenden FET 36 zugeführt. Dadurch wird dieser nichtleitend und der Stromfluß durch die in Reihe liegenden FET 36, 25′ und 23′ unterbrochen, so daß keine Gleichstromverlustleistung erzeugt wird.

Beim Schalten des Leistungsverstärkers vom hohen in den niedrigen Ausgangspegel wird dem Dateneingang DN des Leistungsverstärkers ein negatives Potential zugeführt. Dadurch wird der p-leitende Vorstufen-FET 27′ leitend und führt dem Gate des n-leitenden Endstufen-FET 30′ positives Potential zu. Dieser FET beginnt leitend zu werden und die Kapazität $C_O$ zu entladen. Am Gate des Zusatz-FET 29′ liegt ein positives Potential, so daß dieser FET leitend ist. Auch der mit ihm in Reihe liegende n-leitende FET 31 ist leitend, da seinem Gate über den leitenden FET 33, dessen Gate mit dem des Endstufen-FET 30' verbunden ist, das absinkende positive Potential des Ausgangs O' zugeführt wird. Die beiden n-leitenden FET 31 und 29' sorgen dafür, daß sich das Potential am Gate des Endstufen-FET 30' nur so langsam ändert als es der gewünschten Ausgangsimpedanz entspricht. Nachdem das Potential des Ausgangs O' den niedrigen Wert angenommen hat, wird es über den leitenden FET 33 zum Gate des n-leitenden FET 31 übertragen, der dadurch sperrt. Damit ist das Entstehen einer Gleichstromverlustleistung für die Zeit, in der der Leistungsverstärker nicht schaltet, verhindert.

Der FET 32 bzw. 34 dient dazu, das Gate des nach einem Schaltvorgang gesperrten FET 36 bzw. 31, beim nächsten Schaltvorgang wieder zu entladen, damit bei einem dritten Schaltvorgang der FET 36 bzw. 29 zunächst wieder leitend ist.

Die für die Regelschaltung nach Fig.1 benötigten Spannungsteilerwiderstände R1 und R2 sind als diffundierte p-leitende Streifen in einer n-leitenden Wanne auf dem Halbleiterchip realisiert. Die die gewünschte erhöhte Ausgangsimpedanz bestimmenden Widerstände R3 und R4 sind entweder außerhalb des Chips angeordnet oder auf ihm ebenfalls als diffundierte p-leitende Streifen in einer n-leitenden Wanne realisiert. Über durchtrennbare Sicherungen können die Widerstände abgeglichen werden. Zur Temperaturkompensation kann eine Diode in Reihe geschaltet sein.

Die Endstufen-Feldeffekttransistoren können aus mehreren gleich dimensionierten und parallel geschalteten Feldeffekttransistoren zusammengesetzt sein. In diesem Fall müssen die Widerstände R3 und R4 der Regelschaltung nach Fig. 1 einen Wert aufweisen, der einem ganzzahligen Vielfachen der gewünschten Ausgangsimpedanz des zusammengesetzten Endstufen-Feldeffekttransistors entspricht. Das ganzzahlige Vielfache ist dabei durch die Anzahl der parallel geschalteten Feldeffekttransistoren bestimmt.

## Ansprüche

1. Verfahren zum Erhöhen der Ausgangsimpedanz auf einen vorgegebenen Wert beim Schalten eines in CMOS-Technologie ausgeführten integrierten Leistungsverstärkers zwischen zwei Spannungspegeln, dadurch gekennzeichnet, daß die Ausgangsimpedanz jedes Leistungsverstärkers über die Steuerspannung des jeweils schaltenden Endstufen-Feldeffekttransistors (26, 30) auf den vorgegebenen Wert gebracht wird.

2. Verfahren nach Anspruch 1, dadurch gekennzeichnet, daß die Steuerspannung für den Endstufen-Feldeffekttransistor verringert wird.

3. Verfahren nach den Ansprüchen 1 und 2, dadurch gekennzeichnet, daß das Verringern der Steuerspannung über den Strom eines Zusatz-Feldeffekttransistor (25, 29) erfolgt, der mit seiner Drain an das Gate des zugehörigen Endstufen-Feldeffekttransistors angeschlossen ist.

4. Verfahren nach den Ansprüchen 1 bis 3, dadurch gekennzeichnet, daß das Verringern der Steuerspannung des p-leitenden Endstufen-Feldeffekttransistors durch die Potentialerhöhung erfolgt, die der Strom des Zusatz-Feldeffekttransistors (25) beim Durchfließen des n-leitenden Feldeffekttransistors (23) der Vorstufe an deren Ausgang (O1) hervorruft.

5. Verfahren nach den Ansprüchen 1 bis 3, dadurch gekennzeichnet, daß das Verringern der Steuerspannung des n-leitenden Endstufen-Feldeffekttransistors (30) durch ein Absenken seines Gate-Potentials erfolgt, das durch den Strom des Zusatz-Feldeffekttransistors (29) am Ausgang (O2) der Vorstufe verursacht wird.

6. Verfahren nach den Ansprüchen 1 bis 5, dadurch gekennzeichnet, daß die Steuerspannung für jeden Zusatz-Feldeffekttransistor in einer Regelschaltung gewonnen wird.

7. Schaltungsanordnung zur Durchführung des Verfahrens nach den Ansprüchen 1 bis 6, dadurch gekennzeichnet, daß die Regelschaltung für jeden Endstufen-Feldeffekttransistor enthält:

a) einen Differenzverstärker (1-5, 12-16), dessen eine Eingangsklemme (I1, I4)) mit dem Abgriff (A) eines Spannungsteilers für die Betriebsspannung (VH) verbunden ist, der aus zwei gleichgroßen Widerständen (R1, R2) aufgebaut ist und an seinem Abgriff (A) die halbierte Betriebsspannung (VH/2) liefert, und dessen zweite Eingangsklemme (I2, I3) angeschlossen ist an den Verbindungspunkt eines den gewünschten Wert der Ausgangsimpedanz des Endstufen-Feldeffekttransistors bzw. ein ganzzahliges Vielfaches davon vorgebenden Widerstandes (R3, R4) mit der Drain eines den Endstufen-Feldeffekttransistor (26, 30) des Leistungsverstärker nachbildenden Feldeffekttransistors (11, 22), an dessen Gate auch die Drain-Elektroden zweier den Zusatz-Feldeffekttransistor (25, 29) und den Vorstufen-Feldeffekttransistor (23, 27) des Leistungsverstärkers nachbildende Feldeffekttransistoren (8, 9; 21, 20) angeschlossen sind,

b) einen an den Ausgang (O3, O5) des Differenzverstärkers angeschlossenen Inverter (6, 7; 17, 18), mit dessen Ausgang (O4, O6) das Gate des den Zusatz-Feldeffekttransistor (25, 29) des Leistungsverstärkers nachbildenden Feldeffekttransistors (9, 21) verbunden ist, sowie die Gate-Elektroden der Zusatz-Feldeffekttransistoren aller Leistungsverstärker, deren Ausgangsimpedanz beim Schalten auf einen vorgegebenen Wert erhöht werden soll.

8. Schaltungsanordnung zur Durchführung des Verfahrens nach den Ansprüchen 1 bis 6, dadurch gekennzeichnet,
daß der Leistungsverstärker für jeden Endstufen-Feldeffekttransistor (26, 30) einen Zusatz-Feldeffekttransistor (25, 29) vom gleichen Leitfähigkeitstyp, wie der Endstufen-Feldeffekttransistor aufweist,
daß die Drain des Zusatz-Feldeffekttransistors (25, 29) an das Gate des Endstufen- Feldeffekttransistors (26, 30), seine Source an den positiven (VH) bzw. an den mit dem Bezugspotential verbundenen Pol der Betriebsspannungsquelle und sein Gate an den Ausgang CP bzw. CN der Regelschaltung angeschlossen ist.

9. Schaltungsanordnung nach Anspruch 8, dadurch gekennzeichnet,
daß mit jedem Zusatz-Feldeffekttransistor (25', 29') ein erster weiterer Feldeffekttransistor (36, 31) gleichen Leitfähigkeitstyps in Reihe geschaltet ist, dessen Gate einmal über einen zweiten weiteren FET (35, 33) gleichen Leitfähigkeitstyps an den Ausgang (O') des Leistungsverstärkers angeschlossen ist und über einen dritten weiteren komplementären Feldeffekttransistor (34, 32) an den mit dem Bezugspotential verbundenen bzw. an den positiven (VH) Pol der Betriebsspannungsquelle angeschlossen ist, und
daß die Gate-Elektrode der komplementären zweiten und dritten weiteren Feldeffekttransistoren (34, 35 bzw. 32, 33) miteinander und mit dem Gate des zugehörigen Endstufen-Feldeffekttransistors (26', 30') verbunden sind.

10. Schaltungsanordnung nach Anspruch 7, dadurch gekennzeichnet,
daß die die gewünschte erhöhte Ausgangsimpedanz des Leistungsverstärkers vorgebenden Widerstände (R3, R4) der Regelschaltung außerhalb des Halbleiterchips angeordnet sind.

11. Schaltungsanordnung nach Anspruch 7, dadurch gekennzeichnet,
daß die die gewünschte erhöhte Ausgangsimpedanz des Leistungsverstärkers vorgebenden Widerstände (R3, R4) der Regelschaltung auf dem Halbleiterchip als streifenförmige Diffusionswiderstände in einer N-leitenden Wanne realisiert und über durchtrennbare Sicherungen abgleichbar sind und zur Temperaturkompensation mit einer Diode in Reihe liegen.

12. Schaltungsanordnung nach Anspruch 8, dadurch gekennzeichnet,
daß die Endstufen-Feldeffekttransistoren (26, 30) aus mehreren gleich dimensionierten und parallel geschalteten Feldeffekttransistoren bestehen.

FIG. 1

FIG. 2

FIG. 3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.3) |
|---|---|---|---|
| X | IBM TECHNICAL DISCLOSURE BULLETIN, Band 30, Nr. 9, Februar 1988, Seiten 174-176, Armonk, NY, US; "Low L di/dt noise off-chip driver" * Figuren 1,2; Seiten 174-176 * --- | 1-3,8,9 | H 03 K 19/003 H 03 K 17/16 |
| A | US-A-4 504 779 (HAMAN) * Figuren 1,2; Spalte 2, Zeile 1 - Seite 4, Zeile 47 * --- | 1-5 | |
| A | US-A-4 622 482 (GANGER) * Figuren; Seite 3, Zeile 5 - Seite 5, Zeile 4 * --- | 1-5 | |
| A | US-A-4 739 193 (DOTY, II) * Figuren 1,5; Seite 2, Zeile 25 - Seite 3, Zeile 47; Seite 4, Zeilen 35-47 * --- | 1 | |
| A | US-A-4 758 743 (DEHGANPOUR et al.) --- | 1 | RECHERCHIERTE SACHGEBIETE (Int. Cl.3) |
| A | IBM TECHNICAL DISCLOSURE BULLETIN, Band 27, Nr. 1A, Juni 1984, Seiten 13-14, Armonk, NY, US; E.H. STOOPS: "Circuit to control the time rate of change of current at the output node of an off-chip driver" --- | 1 | H 03 K |
| A | DE-A-3 627 681 (HITACHI LTD) ----- | 1,12 | |

Der vorliegende Recherchenbericht wurde für alle Patentansprüche erstellt

| Recherchenort | Abschlußdatum der Recherche | Prüfer |
|---|---|---|
| DEN HAAG | 08-06-1989 | FEUER F.S. |